# EUROPEAN PATENT SPECIFICATION

(11) **EP 2 857 849 B1**
(45) Date of publication and mention of the grant of the patent: **02.11.2016**
(21) Application number: 13004746.7
(22) Date of filing: 01.10.2013
(51) Int. Cl.: G01R 15/06, G01R 15/16, B60L 5/00, H01F 30/08, G01R 1/30

(54) **Electrical voltage measuring apparatus**
Elektrische Spannungsmessvorrichtung
Appareil de mesure tension électrique

(43) Date of publication of application: 08.04.2015
(73) Proprietor: Sécheron SA, 1242 Satigny (CH)
(72) Inventor: Schaerrer, Marc, 1233 Bernex (CH); Venzin, Nicolas, 74250 Fillinges (FR); Tricarico, Claudio, 1260 Nyon (CH)
(74) Representative: Micheli & Cie SA

(56) References cited:
- EP-A2- 1 947 465
- WO-A2-2011/007081
- DE-A1- 19 855 528

## Description

### TECHNICAL FIELD OF THE INVENTION

The present invention relates to an electrical measuring apparatus for measuring an alternating voltage between a first electrical potential and a second electrical potential. More particularly, the present invention relates to such an apparatus for measuring high alternating voltages, i.e. voltages above 1 kV, typically of 15 kV (at 16.7 Hz) or 25 kV (at 50 Hz). One preferred application of the present invention consists in measuring the voltage supplied by an overhead line to a railway vehicle for its propulsion.

### TECHNICAL BACKGROUND

Electrical measuring apparatuses are known in which an electronic circuit which measures a reduced voltage or a current and calculates therefrom the high voltage is placed in the high-voltage section of the apparatus; see e.g. WO 2011/007081, EP 1947465 and EP 2224251. In such apparatuses, the power that drives the electronic circuit is supplied from the low-voltage section of the apparatus via a transformer which galvanically isolates the low-voltage section from the high-voltage section. To accommodate both the transformer and the measuring device that provides the reduced voltage or the current, generally a voltage divider, the apparatus must have a sufficient size. To decrease the size of the apparatus it has been proposed in WO 2011/007081 to use a transformer having primary and secondary windings but no magnetic core, and to place the voltage divider (a resistive divider) so that it extends through the primary and secondary windings. Such an arrangement is however disadvantageous in that parasitic capacitances are formed between the voltage divider and the windings, which will affect the voltage divider, especially for fast voltage variations. Moreover the windings are close to one another and to the exterior of the apparatus. This may result in the electrical field being locally strong between the two windings, between the windings and the voltage divider and at the interface between the outside air and the insulating medium filling the inside of the apparatus, thus increasing the risk of electrical breakdown.

### SUMMARY OF THE INVENTION

The present invention aims at remedying, at least partly, the above-mentioned drawbacks and provides to this effect an electrical measuring apparatus for measuring an alternating voltage between a first potential and a second potential comprising a voltage measuring device, a measuring electronic circuit and a transformer for supplying power to the measuring electronic circuit, the transformer comprising a primary side and a secondary side magnetically coupled to one another, characterised in that the voltage measuring device comprises:
- a first electrode arranged to be electrically connected to the first potential,
- a second electrode arranged to be electrically connected to the second potential, and
- a third electrode separate from the first and second electrodes, the first and third electrodes being electrically connected to the measuring electronic circuit,
and in that the primary side is disposed in the second electrode and the secondary side is disposed in the first electrode.

Preferably, the second electrode comprises a main body defining a recess in which a first insulating plate is mounted, said first insulating plate being covered with a first conductive layer which is conductively connected to the main body and which defines an external surface portion of the second electrode, said external surface portion facing the third electrode.

Advantageously, the first conductive layer is designed so as to limit eddy currents. To this end the first conductive layer may be designed so as to define at least one comb shape.

The primary side may comprise an inductance member in the form of internal conductive layers of the first insulating plate.

The primary side may further comprise a magnetic core mounted on or close to the first insulating plate.

Preferably, the first electrode defines a recess in which a second insulating plate is mounted, said second insulating plate being covered with the third electrode.

Advantageously, the third electrode is designed so as to limit eddy currents. To this end the third electrode may be designed so as to define at least one comb shape.

The secondary side may comprise an inductance member in the form of internal conductive layers of the second insulating plate.

The secondary side may further comprise a magnetic core mounted on or close to the second insulating plate.

Typically, the measuring electronic circuit is within the first electrode.

The measuring electronic circuit may comprise a capacitor electrically connected between the first and third electrodes, and a device for measuring a voltage across said capacitor and deducing therefrom a value of said alternating voltage.

Alternatively, the measuring electronic circuit may comprise an operational amplifier arranged to act as an integrator, a first input of the operational amplifier being electrically connected to the third electrode, a second input of the operational amplifier being electrically connected to the first electrode, and a device for measuring a voltage at an output of the operational amplifier and deducing therefrom a value of said alternating voltage.

The present invention further proposes to use an electrical measuring apparatus as defined above for measuring an alternating voltage supplied to a railway vehicle.

### BRIEF DESCRIPTION OF THE DRAWINGS

Other features and advantages of the present invention will be apparent upon reading the following detailed description made with reference to the appended diagrammatic drawings in which:
- Figure 1 shows in cross-section an electrical measuring apparatus according to the invention;
- Figure 2 shows part of an electronic circuit included in the electrical measuring apparatus according to the invention;
- Figure 3 shows part of the said electronic circuit, according to a variant of the invention;
- Figure 4 shows in cross-section a multilayer structure used in the electrical measuring apparatus according to the invention;
- Figures 5 and 6 are plane view of two design examples of conductive layers used in the electrical measuring apparatus according to the invention; and
- Figure 7 shows another part of the said electronic circuit.

### DETAILED DESCRIPTION

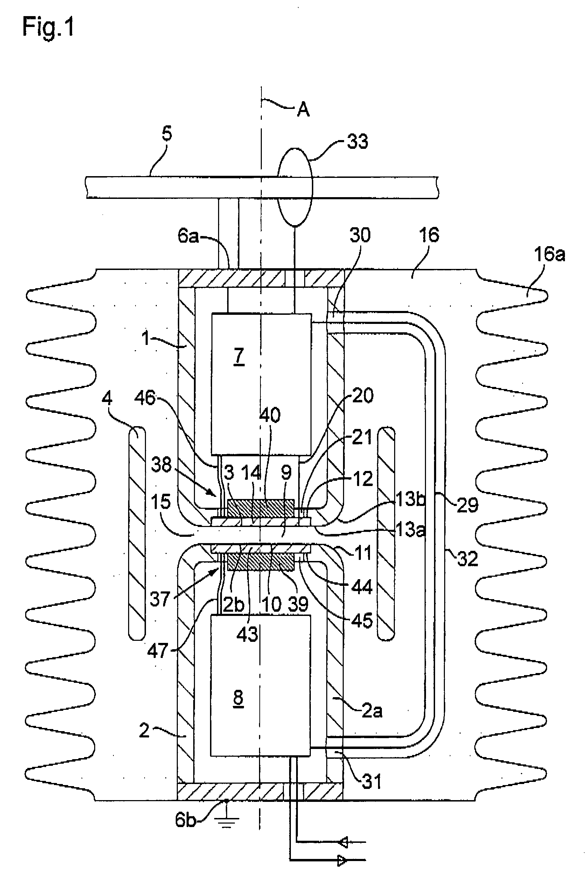

Referring to Figure 1, a capacitive-type electrical measuring apparatus according to the present invention comprises four electrodes 1 to 4.

The first electrode 1 is electrically connected to a high potential to be measured, supplied by a high-voltage electrical line 5. The point of contact between the first electrode 1 and the high-voltage electrical line 5 is designated by reference numeral 6a. The second electrode 2 is electrically connected to a low potential, typically but not exclusively the ground (earth) potential. The point of contact between the second electrode 2 and the source of low potential is designated by reference numeral 6b. The first and second electrodes 1, 2 have generally cylindrical shapes extending along a common axis A, with preferably substantially identical diameters, are hollow to receive electronic circuits 7, 8 and are separated by a space 9. The external surface 10 of the second electrode 2 that faces the first electrode 1 is flat and perpendicular to the axis A except for its edge 11 which is rounded to avoid creating a strong local electrical field. As will be explained in more details later, the second electrode 2 comprises a main body 2a and a conductive layer 2b deposited on a disc-shaped insulating plate 43, with the conductive layer 2b being conductively connected to the main body 2a and defining a central portion of the external surface 10. The external surface of the first electrode 1 that faces the second electrode 2 defines in its central portion a recess 12 having a flat annular bottom perpendicular to the axis A. Radially beyond the recess 12 the said external surface of the first electrode 1 has a peripheral flat surface portion 13a terminating in a rounded edge 13b.

The third electrode 3 is provided in the space 9 between the first and second electrodes 1, 2, and more precisely in the recess 12 of the first electrode 1. In the example shown, the third electrode 3 is in the form of a conductive layer deposited on a disc-shaped insulating plate 14 mounted (e.g. bonded) in the recess 12 against the flat annular bottom thereof so as to be coaxial with the first and second electrodes 1, 2. The thicknesses of the recess 12, insulating plate 14 and third electrode 3 are preferably such that the third electrode 3 is flush with the peripheral surface portion 13a. The third electrode 3 however does not contact the first electrode 1. This arrangement of the first, second and third electrodes 1, 2, 3 enables the electrical field to be substantially uniform in the space 9 and particularly in the space between the second and third electrodes 2, 3. Since it is close to the third electrode 3 and has a larger diameter than this latter, the first electrode 1 shields the third electrode 3. Arranging the third electrode 3 so that it is flush with the peripheral surface portion 13a gives the equipotentials a continuous and smooth shape in the space 9 and avoids the need for the electrode 3 to have rounded edges. The second and third electrodes 2, 3 together form a first measuring capacitor.

The fourth electrode 4 is a floating-potential electrode in the form of a tube coaxial with the first, second and third electrodes 1, 2, 3. The fourth electrode 4 faces and surrounds a circular peripheral opening 15 of the space 9, i.e. the opening through which the equipotentials starting between the first, second and third electrodes 1, 2, 3 pass and extend away from the first, second and third electrodes 1, 2, 3. More precisely, the fourth electrode 4 overlaps the first and second electrodes 1, 2 and surrounds a zone including the third electrode 3, part of the first electrode 1 and part of the second electrode 2. In this manner, the fourth electrode 4 shields the operative electrical field in the space 9 from the influence of extraneous objects which could disturb the measurement, and homogenises the electrical field outside the apparatus.

The electrodes 1 to 4 are each made of a conductive material, typically a metal such as aluminium for the electrodes 1, 4 and the main body 2a of the electrode 2 or such as copper for the electrode 3 and the conductive layer 2b. The electrodes 1 to 4 are embedded in, and thus mutually separated by, an insulating (dielectric) medium or material 16 which is other than air at atmospheric pressure. The insulating medium 16 is preferably a solid material such as an epoxy resin, e.g. an epoxy resin charged with silica, moulded over the electrodes 1 to 4. The insulating plate 14 may also be made of an epoxy resin, such as an epoxy resin filled with glass fibres. Such epoxy resin materials have a dielectric constant that is stable in temperature, frequency and time. Since the dielectric strength of the insulating medium 16 and of the insulating plate 14 is greater than the dielectric strength of air at atmospheric pressure, the gaps between the electrodes 1 to 4 may be reduced and, as a result, a more compact apparatus may be obtained. Moreover the insulating medium 16 is homogeneous and thus avoids the interface weak points which appear frequently in other types of electrical measuring apparatus such as resistive dividers and which create a risk of electrical breakdown.

In a variant the insulating medium 16 is in the form of a gel, liquid or gas contained in a solid tube forming the external envelope of the apparatus. The solid tube may be made of a glass-reinforced composite or porcelain, for example. The insulating medium filling the solid tube may be silicone, polyurethane, oil, a gas such as SF6, air under pressure or vacuum. In such a variant, the fourth electrode 4 may have a rib that engages a groove in the inner wall of the solid tube to hold the fourth electrode 4.

The apparatus according to the invention advantageously takes the shape of an insulator that may also have sheds 16a at its periphery as a protection against the effect of rain and humidity, as is already known. The sheds 16a may be an integral part of the insulating medium 16 or may be added in a second manufacturing step and made from the same or a different material.

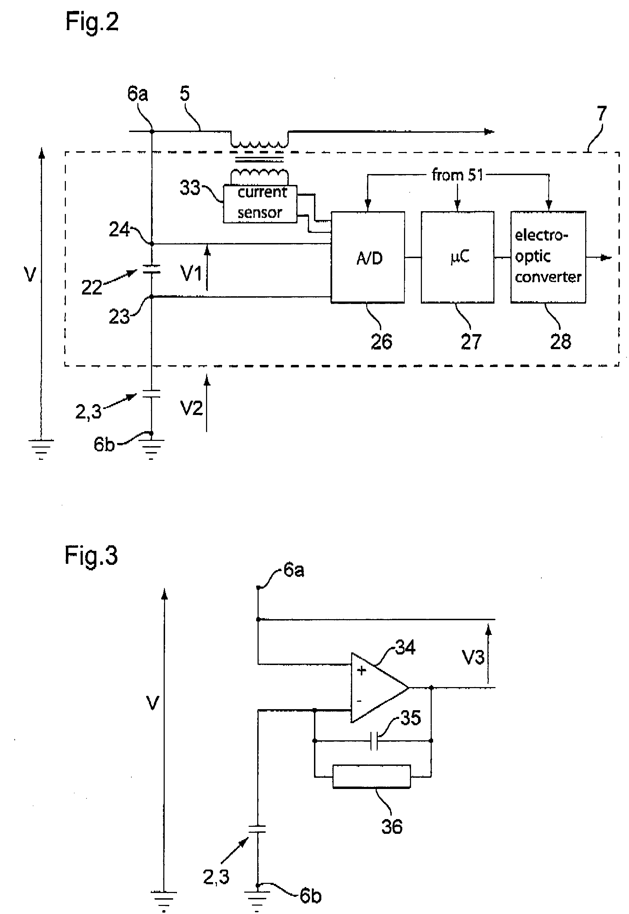

Figure 2 shows how the voltage (or potential difference) V between the contact points 6a, 6b (or in other words between the first and second electrodes 1, 2) is measured. An electrical conductor 20 crossing the central opening 21 of the annular flat bottom of the recess 12 connects the third electrode 3 to a first terminal 23 of a second measuring capacitor 22 in the electronic circuit 7, the second terminal 24 of the second measuring capacitor 22 being connected to the contact point 6a, i.e. to the potential of the first electrode 1. The first measuring capacitor 2, 3 and the second measuring capacitor 22 form together a capacitive voltage divider between the potentials of the first and second electrodes 1, 2. The capacitance of the second measuring capacitor 22 is selected so as to be much greater than the capacitance of the first measuring capacitor 2, 3. The voltage V1 across the second measuring capacitor 22 is therefore much lower than the voltage V2 across the first measuring capacitor 2, 3. In the electronic circuit 7, an analog-to-digital converter 26 measures and digitizes the voltage V1 and a microcontroller 27 processes the digitized voltage to provide a digital value of the high voltage V between the contact points 6a and 6b based on the known capacitances of the first measuring capacitor 2, 3 and of the second measuring capacitor 22. The microcontroller 27 supplies an encoded signal including the said digital value of the high voltage V to an electro-optical converter 28 for its transmission to the electronic circuit 8 in the second electrode 2 via an optical fibre 29. The optical fibre 29 (see Figure 1) interconnects the electronic circuits 7, 8 by passing though openings 30, 31 of the first and second electrodes 1, 2 and through a tunnel 32 formed in the insulating medium 16. The electronic circuit 8 includes an electro-optical converter (not shown) for converting the received optical signal into an electrical signal, a microcontroller (not shown) for decoding the converted electrical signal and a customer interface (not shown) enabling the value of the high voltage V to be retrieved by an operator. Both electronic circuits 7, 8 may further include correction, compensation and filtering means. The electronic circuit 8 may also be placed outside the second electrode 2. The transmission of data between the electronic circuits 7, 8 needs to be isolated but may also be made by other means than an optical fibre, for example by infrared, direct optical link or radio transmission.

In addition to measuring the high voltage V, the electronic circuit 7 may measure the current flowing in the high-voltage electrical line 5. To this end the electronic circuit 7 may comprise a current sensor 33, for example a shunt, an inductive transformer, a Rogowsky coil or any other type of passive or active current sensor. A digitized value of the measured current is then included into the encoded signal transmitted by the optical fibre 29 to be retrievable from the customer interface of the electronic circuit 8. The microcontroller 27 may also calculate, based on the synchronously measured high voltage and current, the power and energy supplied by the high-voltage electrical line 5 and include a value thereof into the encoded signal transmitted by the optical fibre 29. A measured temperature and other signals may also be transmitted from the electronic circuit 7 to the electronic circuit 8.

Figure 3 shows an alternative mode of measurement of the high voltage V. In the example of Figure 3 the third electrode 3 is electrically connected to the negative input of an operational amplifier 34, the positive input of the operational amplifier 34 being connected to the contact point 6a, i.e. to the high potential to be measured. The operational amplifier 34 acts as an integrator. To this effect a feedback loop comprising a capacitor 35 and a resistor 36 in parallel is connected between the output and the negative input of the operational amplifier 34. Such an operational amplifier modifies its output so that its positive and negative inputs have the same potential and, like the capacitor 22 in Figure 2, the capacitor 35 integrates the current flowing through the measuring capacitor 2, 3. The voltage V3 between the positive input and the output of the operational amplifier 34 is proportional to the voltage V to be measured. The voltage V3 is thus measured, digitized and processed by the units 26, 27 to supply a corresponding value of the voltage V to the electronic circuit 8 via the optical fibre 29. With respect to the measurement mode shown in Figure 2 the alternative of Figure 3 has the advantage of being less sensitive to stray resistances and capacitances due to the voltage between the third electrode 3 and the first electrode 1 being substantially zero. In the embodiment of Figure 2 the measuring capacitor 2, 3 withstands the major part of the high voltage V to be measured. In the embodiment of Figure 3, on the other hand, the voltage across the measuring capacitor 2, 3 is the high voltage V to be measured.

Other alternative modes of measurement of the high voltage V may include means for measuring the current flowing from/into the third electrode 3 and means for integrating the measured current digitally.

Arranging the electronic circuits 7, 8 within the first and second electrodes 1, 2, as is shown in Figure 1, renders the overall apparatus more compact and protects the electronic circuits 7, 8 against external electromagnetic perturbations.

In the present invention the electronic circuit 7 which measures the high voltage V is referenced to the high potential of the contact point 6a and of the electrical line 5, The electronic circuit 7 could be powered by a dedicated battery. However this would require regular interventions by an operator in a dangerous, high-voltage zone to replace the battery. Another solution could be to embed in the insulating medium 16 a transformer for supplying power to the electronic circuit 7 from the low-voltage side of the apparatus (which low-voltage side could be itself powered from the outside of the apparatus). However this would increase the size of the apparatus and would require the transformer to be specially designed to avoid electrical breakdowns between its primary and secondary sides.

The solution proposed by the present invention to power the electronic circuit 7 is to integrate a transformer into the electrode arrangement 1 to 3. As shown in Figure 1, a transformer is provided which comprises a primary side 37 and a secondary side 38. The primary side 37 is located in the second electrode 2 and the secondary side 38 is located in the first electrode 1.

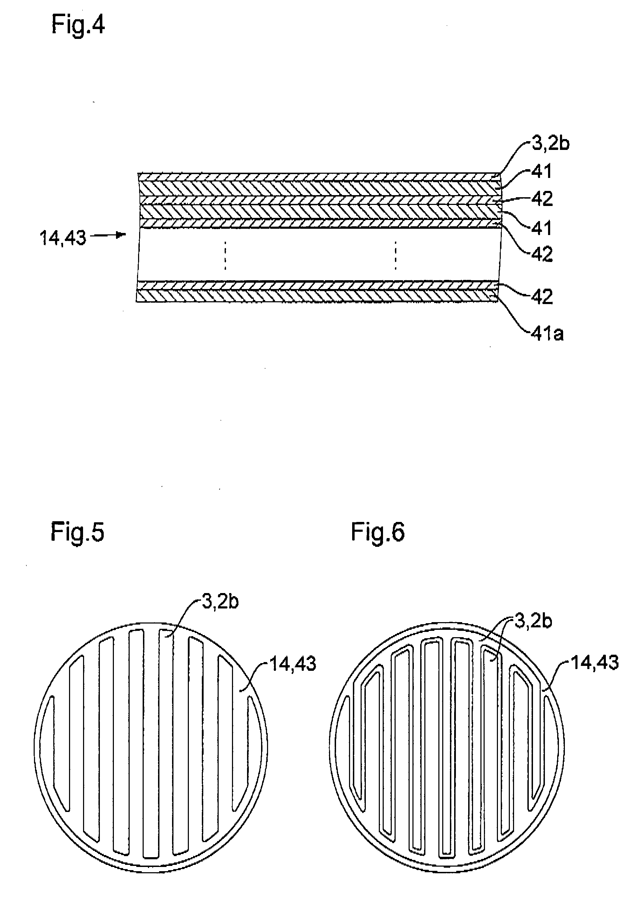

Each of the primary and secondary sides 37, 38 comprises an inductance member, typically a coil, and a magnetic core 39, 40 to improve the magnetic coupling between the inductance members. The magnetic cores 39, 40 typically have a disc shape. Preferably, the inductance member of the primary side 37 is in the form of internal conductive layers of the insulating plate 43 and the inductance member of the secondary side 38 is in the form of internal conductive layers of the insulating plate 14, the conductive layers each having a planar spiral shape, according to a design that is known per se. Figure 4 diagrammatically shows the multilayer structure of the insulating plates 14, 43. As is apparent, the insulating plates 14, 43 each comprise an alternation of insulating layers 41 made of an epoxy resin filled with glass fibres, for example, and conductive layers 42 made of copper, for example. The conductive layers 42 are shaped as planar spirals to define together an inductance coil. At one of its two sides the multilayer structure is covered with the third electrode 3 (for the insulating layer 14) or with the conductive layer 2b (for the insulating plate 43). At its other side the multilayer structure may be terminated by an insulating layer 41a. The insulating plates 14, 43 may be made using a printed circuit board technology.

As already mentioned, the third electrode 3 does not contact the first electrode 1, whereas the conductive layer 2b is conductively connected to the electrode body 2a to form therewith the second electrode 2. As diagrammatically shown in Figures 5 and 6, the third electrode 3 and the conductive layer 2b are preferably formed according to a design or pattern that limits the eddy currents, e.g. are designed as a comb (figure 5) or as two interlaced and separate combs (figure 6). In Figures 5 and 6 the width of each tooth of the comb(s) and of each gap between the teeth has been exaggerated for illustration purposes. Alternative ways of limiting the eddy currents could be to just provide slits in the third electrode 3 and the conductive layer 2b and/or to make the third electrode 3 and the conductive layer 2b of a material having a high electric resistance, such as a conductive paint or a conductive plastic material or resin. In each of the aforementioned embodiments the eddy currents may be further limited by making the third electrode 3 and conductive layer 2b very thin.

The insulating plate 14 may further include, between the electrode 3 and its adjacent insulating layer 41 shown in Figure 4, a superposition of an insulating layer adjacent to the electrode 3 and of a shielding conductive layer, the shielding conductive layer being conductively connected to the first electrode 1 (e.g. by means of a wire) to have the same potential as the first electrode 1. Such a shielding conductive layer shields the electronic circuit 7 and the electrical field generated by the first, second and third electrodes from one another. Like the electrode 3 and the conductive layer 2b, the shielding conductive layer may have a design that limits the eddy currents, such as the design shown in Figure 5 or 6.

The magnetic core 40 is mounted on the side of the insulating plate 14 opposite to the side that supports the electrode 3, and extends through the opening 21 of the first electrode 1 that makes the recess 12 communicate with the inside of the first electrode 1. Similarly to the insulating plate 14 with respect to the first electrode 1, the insulating plate 43 is mounted in a recess 44 of the main body 2a of the second electrode 2, against a flat annular bottom of the said recess, which recess 44 is opposite to the recess 12 and communicates with the inside of the second electrode 2 through the opening 45 of the flat annular bottom. The magnetic core 39 is mounted on the side of the insulating plate 43 opposite to the side that supports the conductive layer 2b, and extends through the opening 45.

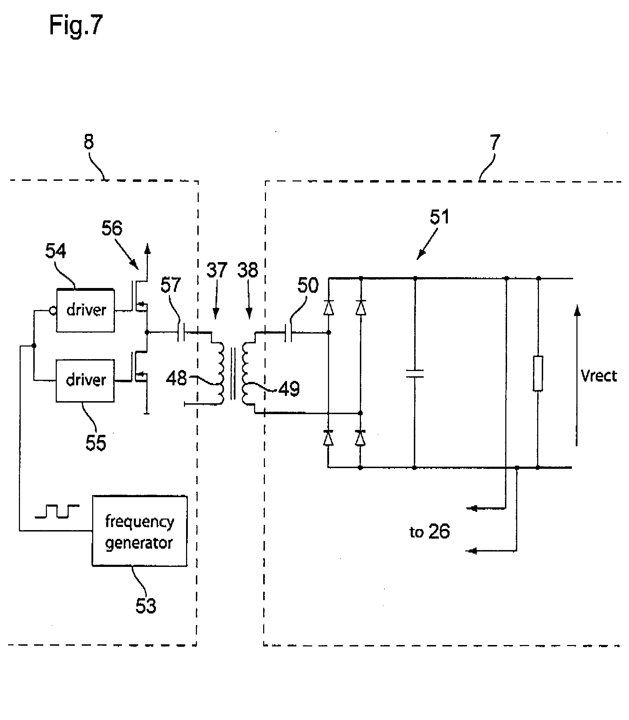

Conductors 46, 47 crossing the openings 21, 45 electrically connect the inductance members in the plates 14, 43 to the electronic circuits 7, 8 respectively. In Figure 7 the inductance member of the primary side 37 is designated by reference numeral 48 and the inductance member of the secondary side 38 is designated by reference numeral 49. The inductance member 49 is connected to a capacitor 50 in the electronic circuit 7 to form therewith a resonant circuit. The resonant circuit is connected to a rectifier 51 which outputs a rectified voltage Vrect which will power the rest of the electronic circuit 7, particularly the analog-to-digital converter 26, the microcontroller 27, the operational amplifier 34 and the electro-optical converter 28. The rectified voltage Vrect is also measured and digitized by the analog-to-digital converter 26 and then included by the microcontroller 27 into the encoded signal transmitted via the optical fibre 29 to the electronic circuit 8. In the electronic circuit 8 a frequency generator 53 controlled by the microcontroller (not shown) that decodes the signal received from the optical fibre 29 outputs a square-wave signal the frequency of which depends on the measured value of the rectified voltage Vrect, as is known per se. The square-wave signal is provided to drivers 54, 55 which drive a half-bridge 56 (or, in a variant, a full bridge) which in turn provides an alternating voltage to a resonant circuit comprising a capacitor 57 connected to the inductance member 48 of the primary side 37. The voltage Vrect which powers the electronic circuit 7 is thus regulated so as to stay in a predetermined voltage range.

In a variant of the invention, each insulating plate 43, 14 may be made of two plates fixed (e.g. bonded) to one another, one of these plates supporting the conductive layer 2b or the electrode 3 and the other plate having the internal conductive layers that define the inductance member. In another variant the inductance member of each of the primary and secondary sides 37, 38 may be realized in a plate or printed circuit board that is separate from the insulating plate 43, 14, respectively, but mounted close to the said insulating plate 43, 14. In still another variant the inductance member of each of the primary and secondary sides 37, 38 may be realized as a non-planar winding made of wound insulated wire mounted on or close to the insulating plate 43, 14. Instead of being mounted on the insulating plates 43, 14, the magnetic cores 39, 40 could be mounted close to the insulating plates 43, 14, respectively, on supports provided within the electrodes 2, 1.

Due to its integration in the electrode arrangement 1 to 3, the transformer 37, 38 does not increase the size of the apparatus which may therefore be compact. Moreover, the transformer 37, 38 benefits from the high-voltage setup created by the electrodes 1 to 4, and does not need to be specially designed (with rounded edges, etc.) for avoiding electrical breakdowns or partial discharges.

The apparatus according to the invention may be mounted on the roof or under the car body of a railway vehicle (typically a locomotive) to measure the high voltage supplied by the overhead line to the said vehicle for its propulsion. If the apparatus is also able to measure the current drawn from the overhead line, the energy supplied to the railway vehicle may be calculated for billing purposes. In such a railway application, the low-voltage electronic circuit 8 may be powered by the battery circuits of the railway vehicle.

The present invention has been described above by way of example only. It is clearly apparent to the skilled person that modifications may be made without departing from the scope of the claimed invention. In particular, the shape of the electrodes 1 to 4 could be different. For example, each of the first and second electrodes 1, 2 could be shaped to have a cylindrical portion near the third electrode 3 and the conductive layer 2b and a smaller-diameter cylindrical portion in the vicinity of the contact point 6a, 6b. The fourth electrode 4 could have a conical shape or a tubular shape with a varying-thickness wall.

## Claims

1. Electrical measuring apparatus for measuring an alternating voltage between a first potential and a second potential, comprising a voltage measuring device (1-3), a measuring electronic circuit (7) and a transformer (37, 38) for supplying power to the measuring electronic circuit (7), the transformer comprising a primary side (37) and a secondary side (38) magnetically coupled to one another, **characterised in that** the voltage measuring device comprises:
- a first electrode (1) arranged to be electrically connected to the first potential,
- a second electrode (2) arranged to be electrically connected to the second potential, and
- a third electrode (3) separate from the first and second electrodes (1, 2), the first and third electrodes (3) being electrically connected to the measuring electronic circuit (7),
and **in that** the primary side (37) is disposed in the second electrode (2) and the secondary side (38) is disposed in the first electrode (1).

2. Electrical measuring apparatus according to claim 1, **characterised in that** the second electrode (2) comprises a main body (2a) defining a recess (44) in which a first insulating plate (43) is mounted, said first insulating plate (43) being covered with a first conductive layer (2b) which is conductively connected to the main body (2a) and which defines an external surface portion (10) of the second electrode (2), said external surface portion (10) facing the third electrode (3).

3. Electrical measuring apparatus according to claim 2, **characterised in that** the first conductive layer (2b) is designed so as to limit eddy currents.

4. Electrical measuring apparatus according to claim 3, **characterised in that** the first conductive layer (2b) is designed so as to define at least one comb shape.

5. Electrical measuring apparatus according to any one of claims 2 to 4, **characterised in that** the primary side (37) comprises an inductance member (48) in the form of internal conductive layers (41) of said first insulating plate (43).

6. Electrical measuring apparatus according to claim 5, **characterised in that** the primary side (37) further comprises a magnetic core (39) mounted on or close to the first insulating plate (43).

7. Electrical measuring apparatus according to any one of claims 1 to 6, **characterised in that** the first electrode (1) defines a recess (12) in which a second insulating plate (14) is mounted, said second insulating plate (14) being covered with the third electrode (3).

8. Electrical measuring apparatus according to claim 7, **characterised in that** the third electrode (3) is designed so as to limit eddy currents.

9. Electrical measuring apparatus according to claim 8, **characterised in that** the third electrode (3) is designed so as to define at least one comb shape.

10. Electrical measuring apparatus according to any one of claims 7 to 9, **characterised in that** the secondary side (38) comprises an inductance member (49) in the form of internal conductive layers (41) of said second insulating plate (14).

11. Electrical measuring apparatus according to claim 10, **characterised in that** the secondary side (38) further comprises a magnetic core (40) mounted on or close to the second insulating plate (14).

12. Electrical measuring apparatus according to any one of claims 1 to 11, **characterised in that** the measuring electronic circuit (7) is within the first electrode (1).

13. Electrical measuring apparatus according to any one of claims 1 to 12, **characterised in that** the measuring electronic circuit (7) comprises a capacitor (22) electrically connected between the first and third electrodes (1, 3), and a device (26-27) for measuring a voltage across said capacitor (22) and deducing therefrom a value of said alternating voltage.

14. Electrical measuring apparatus according to any one of claims 1 to 12, **characterised in that** the measuring electronic circuit (7) comprises an operational amplifier (34) arranged to act as an integrator, a first input of the operational amplifier (34) being electrically connected to the third electrode (3), a second input of the operational amplifier (34) being electrically connected to the first electrode (1), and a device (26-27) for measuring a voltage at an output of the operational amplifier (34) and deducing therefrom a value of said alternating voltage.

15. Use of an electrical measuring apparatus according to any one of claims 1 to 14 for measuring an alternating voltage supplied to a railway vehicle.

## Patentansprüche

1. Elektrische Messvorrichtung zur Messung einer Wechselspannung zwischen einem ersten Potential und einem zweiten Potential, umfassend eine Spannungsmessvorrichtung (1-3), eine Messelektronik (7) und einen Transformator (37, 38) um die Messelektronik (7) mit Energie zu versorgen, wobei der Transformator (37, 38) eine Primärseite (37) und eine Sekundärseite (38) aufweist, die magnetisch miteinander gekoppelt sind,
**dadurch gekennzeichnet, dass** die Spannungsmessvorrichtung folgendes umfasst:
- eine erste Elektrode (1) in elektrischem Kontakt mit dem ersten Potential,
- eine zweite Elektrode (2) in elektrischem Kontakt mit dem zweiten Potential, und
- eine dritte Elektrode (3), die von der ersten Elektrode (1) und der zweiten Elektrode (2) getrennt ist, wobei die erste Elektrode (1) und die dritte Elektrode (3) einen elektrischen Kontakt zur Messelektronik (7) aufweisen,
und dadurch, dass die Primärseite (37) in der zweiten Elektrode (2) angeordnet ist und die Sekundärseite (38) in der ersten Elektrode (1) angeordnet ist.

2. Elektrische Messvorrichtung nach Anspruch 1, **dadurch gekennzeichnet, dass** die zweite Elektrode (2) einen Grundkörper (2a) aufweist, der eine Ausnehmung (44) definiert, in der eine erste Isolierplatte (43) befestigt ist, wobei die erste Isolierplatte (43) mit einer ersten leitfähigen Schicht (2b) versehen ist, welche leitend mit dem Grundkörper (2a) verbunden ist und welche einen äußeren Oberflächenabschnitt (10) der zweiten Elektrode (2) darstellt, wobei der äußere Oberflächenabschnitt (10) der dritten Elektrode (3) zugewandt ist.

3. Elektrische Messvorrichtung nach Anspruch 2, **dadurch gekennzeichnet, dass** die erste leitfähige Schicht (2b) derart ausgebildet ist, dass sie Wirbelströme limitiert.

4. Elektrische Messvorrichtung nach Anspruch 3, **dadurch gekennzeichnet, dass** die erste leitfähige Schicht (2b) derart ausgebildet ist, dass sie mindestens eine kammartige Struktur bildet.

5. Elektrische Messvorrichtung nach einem der Ansprüche 2 bis 4, **dadurch gekennzeichnet, dass** die Primärseite (37) eine Induktivität (48) in Form von inneren leitfähigen Schichten (41) der ersten Isolierplatte (43) umfasst.

6. Elektrische Messvorrichtung nach Anspruch 5, **dadurch gekennzeichnet, dass** die Primärseite (37) zusätzlich einen magnetischen Kern (39) aufweist, der an oder nahe der ersten Isolierplatte (43) befestigt ist.

7. Elektrische Messvorrichtung nach einem der Ansprüche 1 bis 6, **dadurch gekennzeichnet, dass** die erste Elektrode (1) eine Ausnehmung (12) definiert, in der eine zweite Isolierplatte (14) befestigt ist, wobei die zweite Isolierplatte (14) von der dritten Elektrode (3) abgedeckt ist.

8. Elektrische Messvorrichtung nach Anspruch 7, **dadurch gekennzeichnet, dass** die dritte Elektrode (3) derart ausgebildet ist, dass sie Wirbelströme limitiert.

9. Elektrische Messvorrichtung nach Anspruch 8, **dadurch gekennzeichnet, dass** die dritte Elektrode (3) derart ausgebildet ist, dass sie mindestens eine kammartige Struktur bildet.

10. Elektrische Messvorrichtung nach einem der Ansprüche 7 bis 9, **dadurch gekennzeichnet, dass** die Sekundärseite (38) eine Induktivität (49) in Form von inneren leitfähigen Schichten (41) der zweiten Isolierplatte (14) umfasst.

11. Elektrische Messvorrichtung nach Anspruch 10, **dadurch gekennzeichnet, dass** die Sekundärseite (38) zusätzlich einen magnetischen Kern (39) aufweist, der an oder nahe der zweiten Isolierplatte (14) befestigt ist.

12. Elektrische Messvorrichtung nach einem der Ansprüche 1 bis 11, **dadurch gekennzeichnet, dass** die Messelektronik (7) innerhalb der ersten Elektrode (1) angeordnet ist.

13. Elektrische Messvorrichtung nach einem der Ansprüche 1 bis 12, **dadurch gekennzeichnet, dass** die Messelektronik (7) einen Kondensator (22) umfasst, der elektrisch mit der ersten Elektrode (1) und der dritten Elektrode (3) verbunden ist, und eine Vorrichtung (26-27), die die Spannung über den Kondensator (22) misst und daraus den Wert der Wechselspannung ableitet.

14. Elektrische Messvorrichtung nach einem der Ansprüche 1 bis 12, **dadurch gekennzeichnet, dass** die Messelektronik (7) einen Operationsverstärker (34) umfasst, der dazu ausgebildet ist, als Integrator zu wirken, wobei ein erster Eingang des Operationsverstärkers (34) leitend mit der dritten Elektrode (3) verbunden ist und wobei ein zweiter Eingang des Operationsverstärkers (34) leitend mit der ersten Elektrode (1) verbunden ist, und eine Vorrichtung (26-27), die die Spannung an einem Ausgang des Operationsverstärkers (34) misst und daraus den Wert der Wechselspannung ableitet.

15. Verwendung der elektrischen Messvorrichtung nach einem der Ansprüche 1 bis 14 zur Messung einer Wechselspannung, die zur Versorgung eines Schienenfahrzeugs dient.

## Revendications

1. Appareil de mesure électrique pour mesurer une tension alternative entre un premier potentiel et un second potentiel, comprenant un dispositif de mesure de tension (1-3), un circuit électronique de mesure (7) et un transformateur (37, 38) pour alimenter le circuit électronique de mesure (7), le transformateur comprenant un côté primaire (37) et un côté secondaire (38) couplés magnétiquement l'un à l'autre, **caractérisé en ce que** le dispositif de mesure de tension comprend :
- une première électrode (1) agencée pour être reliée électriquement au premier potentiel,
- une seconde électrode (2) agencée pour être reliée électriquement au second potentiel, et
- une troisième électrode (3) distincte des première et seconde électrodes (1, 2), les première et troisième électrodes (3) étant reliées électriquement au circuit électronique de mesure (7),
et **en ce que** le côté primaire (37) est disposé dans la seconde électrode (2) et le côté secondaire (38) est disposé dans la première électrode (1).

2. Appareil de mesure électrique selon la revendication 1, **caractérisé en ce que** la seconde électrode (2) comprend un corps principal (2a) définissant un évidement (44) dans lequel une première plaque d'isolation (43) est montée, ladite première plaque d'isolation (43) étant couverte d'une première couche conductrice (2b) qui est reliée de manière conductrice au corps principal (2a) et qui définit une partie de surface externe (10) de la seconde électrode (2), ladite partie de surface externe (10) faisant face à la troisième électrode (3).

3. Appareil de mesure électrique selon la revendication 2, **caractérisé en ce que** la première couche conductrice (2b) est conçue pour limiter les courants de Foucault.

4. Appareil de mesure électrique selon la revendication 3, **caractérisé en ce que** la première couche conductrice (2b) est conçue pour définir au moins une forme de peigne.

5. Appareil de mesure électrique selon l'une quelconque des revendications 2 à 4, **caractérisé en ce que** le côté primaire (37) comprend un élément inducteur (48) sous la forme de couches conductrices internes (41) de ladite première plaque d'isolation (43).

6. Appareil de mesure électrique selon la revendication 5, **caractérisé en ce que** le côté primaire (37) comprend en outre un noyau magnétique (39) monté sur la première plaque d'isolation (43) ou proche de celle-ci.

7. Appareil de mesure électrique selon l'une quelconque des revendications 1 à 6, **caractérisé en ce que** la première électrode (1) définit un évidement (12) dans lequel une seconde plaque d'isolation (14) est montée, ladite seconde plaque d'isolation (14) étant couverte par la troisième électrode (3).

8. Appareil de mesure électrique selon la revendication 7, **caractérisé en ce que** la troisième électrode (3) est conçue pour limiter les courants de Foucault.

9. Appareil de mesure électrique selon la revendication 8, **caractérisé en ce que** la troisième électrode (3) est conçue pour définir au moins une forme de peigne.

10. appareil de mesure électrique selon l'une quelconque des revendications 7 à 9, **caractérisé en ce que** le côté secondaire (38) comprend un élément inducteur (49) sous la forme de couches conductrices internes (41) de ladite seconde plaque d'isolation (14).

11. Appareil de mesure électrique selon la revendication 10, **caractérisé en ce que** le côté secondaire (38) comprend en outre un noyau magnétique (40) monté sur la seconde plaque d'isolation (14) ou proche de celle-ci.

12. Appareil de mesure électrique selon l'une quelconque des revendications 1 à 11, **caractérisé en ce que** le circuit électronique de mesure (7) est à l'intérieur de la première électrode (1).

13. Appareil de mesure électrique selon l'une quelconque des revendications 1 à 12, **caractérisé en ce que** le circuit électronique de mesure (7) comprend un condensateur (22) relié électriquement entre les première et troisième électrodes (1, 3), et un dispositif (26-27) pour mesurer une tension à travers ledit condensateur (22) et en déduire une valeur de ladite tension alternative.

14. Appareil de mesure électrique selon l'une quelconque des revendications 1 à 12, **caractérisé en ce que** le circuit électronique de mesure (7) comprend un amplificateur opérationnel (34) agencé pour agir comme intégrateur, une première entrée de l'amplificateur opérationnel (34) étant reliée électriquement à la troisième électrode (3), une seconde entrée de l'amplificateur opérationnel (34) étant reliée électriquement à la première électrode (1), et un dispositif (26-27) pour mesurer une tension à une sortie de l'amplificateur opérationnel (34) et en déduire une valeur de ladite tension alternative.

15. Utilisation d'un appareil de mesure électrique selon l'une quelconque des revendications 1 à 14 pour mesurer une tension alternative alimentant un véhicule ferroviaire.
